## Europäisches Patentamt
## European Patent Office
## Office européen des brevets

(11) Veröffentlichungsnummer: **0 126 856 B1**

# EUROPÄISCHE PATENTSCHRIFT

(45) Veröffentlichungstag der Patentschrift:
22.06.88

(51) Int. Cl.⁴: **H 05 K 3/00**

(21) Anmeldenummer: **84102093.6**

(22) Anmeldetag: **29.02.84**

(54) Verfahren zum Herstellen von Leiterplatten mit starren und flexiblen Bereichen.

(30) Priorität: 21.05.83 DE 3318717

(43) Veröffentlichungstag der Anmeldung:
05.12.84 Patentblatt 84/49

(45) Bekanntmachung des Hinweises auf die Patenterteilung:
22.06.88 Patentblatt 88/25

(84) Benannte Vertragsstaaten:
DE FR GB IT

(56) Entgegenhaltungen:
DE - A - 2 914 336
GB - A - 2 101 411
US - A - 3 346 415

(73) Patentinhaber: GRUNDIG E.M.V. Elektro-Mechanische Versuchsanstalt Max Grundig holländ. Stiftung & Co. KG., Kurgartenstrasse 37, D-8510 Fürth/Bay. (DE)

(72) Erfinder: Joens, Robert, Humboldtstrasse 13, D-8502 Zirndorf (DE)
Erfinder: Velte, Lothar, Cadolzburger Weg 27, D-8506 Langenzenn (DE)
Erfinder: Hummel, Manfred, Klausenerstrasse 102, D-8501 Schwarzenbruck-Gsteinach (DE)

## Beschreibung

Die Erfindung betrifft ein Verfahren zum Herstellen von Leiterplatten mit starren und flexiblen Bereichen beliebiger geometrischer Formen, wobei die flexiblen Bereiche als Träger eine flexible Folie aufweisen und bei allen Bearbeitungs- und Bestückungsvorgängen mit dem starren Bereich fest verbunden sind.

Es sind bereits Leiterplatten nach Art gedruckter Schaltungen mit starren und flexiblen Bereichen bekannt, bei denen zunächst starre Leiterplatten sowie flexible Schaltungen einzeln nach den bisher bekannten Verfahren hergestellt und bestückt werden, und anschliessend werden die flexiblen Schaltungsbereiche an die starren Leiterplatten angefügt. Dies führt zu einem aufwendigen Herstellungsverfahren und hat insbesondere den Nachteil, dass für die Weiterverarbeitung der so hergestellten Leiterplatten keine mechanische Einheit zur Verfügung steht, die insbesondere beim Bestücken und Löten gewünscht wird.

Weiterhin ist auch ein Verfahren bekannt, bei dem zur Herstellung von starren und flexiblen Leiterplattenbereichen ein Verpressen von starren und flexiblen Einzellagen vorgesehen ist, und die flexiblen Bereiche durch Entfernen der starren Bereiche entstehen. Die Entfernung der starren Aussenlagen geschieht hierbei entlang der Verbindungslinie zwischen starrem und flexiblem Bereich einerseits dadurch, dass vor dem Verpressen auf der Innenseite der starren Aussenlagen Nuten eingebracht werden und andererseits nach Ausbildung der Leiterzüge und Bestückung der Leiterplatte durch Einbringen korrespondierender Nuten an der Aussenseite. Die starren ungewünschten Bereiche können sodann herausgebrochen werden. Dieser Vorgang ist ebenfalls aufwendig, da mehrfach Nuten einzubringen sind und keine beliebigen Konturen für den flexiblen Bereich möglich sind oder dies nur sehr aufwendig über einen Konturfräsvorgang durchzuführen ist. Bei dieser Art Verfahren können daher zweckmässigerweise nur über die Breite bzw. Länge der Leiterplatte gleichmässig und parallel verlaufende Bruchlinien vorgesehen werden. Eine andere Möglichkeit sieht vor, dass die starren und flexiblen Bereiche dadurch entstehen, dass die Leiterplatte beidseitig vor dem Verbinden der starren und flexiblen Einzelbereiche an den Verbindungslinien vollkommen durchtrennt wird. Die dann beidseitig alles verbindende flexible Folie wird nach üblicher Bearbeitung der Leiterplatte auf einer Seite aufgetrennt, und der starre Teil der Leiterplatte entfernt, da der gegenüberliegende Teil vorsorglich nicht mit der flexiblen Folie verklebt ist. Auch hierbei handelt es sich um ein aufwendiges Verfahren mit einem besonderen Stanzvorgang zum vollständigen Durchtrennen der verschiedenen Bereiche, ebenfalls fehlt für eine ordnungsgemässe Weiterverarbeitung der Leiterplatte die absolut starre Verbindung aller Bereiche, da diese zwar noch beidseitig überspannt sind, doch die durchtrennten Stellen bereits elastisch nachgeben können. Aus DE-A-29 14 336 ist ein Verfahren zur Herstellung starrflexibler Leiterplatten durch Verpressen von starren und flexiblen Einzellagen bekannt, wobei die später flexibel werdenden Bereiche der Leiterplatte mit über die Kontur des Einzelstückes hinaus reichenden durchgehenden Schlitzen innerhalb einer Mehrfachanordnung ausgeschnitten werden. Bei dem bekannten Verfahren werden die Schlitze im unkaschierten Rohmaterial angebracht, und daran anschliessend wird gleichzeitig mit dem auf einer Seite erfolgenden Verpressen der flexiblen Lagen über die gesamte Oberfläche des Rohmaterials ein starres, dünnes, kaschiertes Leiterplattenmaterial mit der unkaschierten Mehrfachplatte auf der anderen Seite verpresst. Nach dem Zerschneiden der Mehrfachplatte in Einzelstücke bleiben diese noch für den weiteren Fertigungsablauf in starrer Form erhalten und die in den flexiblen Bereichen befindlichen starren Teile werden am Ende der Fertigung durch Schneiden oder Brechen herausgelöst.

Der Erfindung liegt nun die Aufgabe zugrunde, ein Verfahren zur Herstellung einer Leiterplatte aus starren und flexiblen Bereichen zu schaffen, die in einfachster und wirtschaftlichster Weise herstellbar ist und einschliesslich der Bauteilbestückung und Verlötung eine kontinuierliche Fertigung nach den bisher für starre Leiterplatten üblichen Fertigungsmethoden ermöglicht, wobei keine zusätzlichen Bearbeitungseinrichtungen erforderlich sein sollen.

Diese Aufgabe wird erfindungsgemäss durch die im kennzeichnenden Teil des Anspruchs 1 angegebenen Merkmale gelöst.

Vorteilhafte Ausgestaltungen des erfindungsgemässen Verfahrens zum Herstellen von Leiterplatten mit starren und flexiblen Bereichen ergeben sich aus den Unteransprüchen.

Ein Ausführungsbeispiel wird nachfolgend anhand der schematischen Zeichnungen näher erläutert.

Es zeigt:

Fig. 1 eine Draufsicht auf eine unkaschierte Basisplatte mit Perforationslinien,
Fig. 2 eine Seitenansicht der Fig. 1, jedoch nach aufgezogener flexibler Folie mit Cu-Kaschierung,
Fig. 3 eine Seitenansicht der Leiterplatte nach Fig. 1 und 2 in Geräte-Einbaulage.

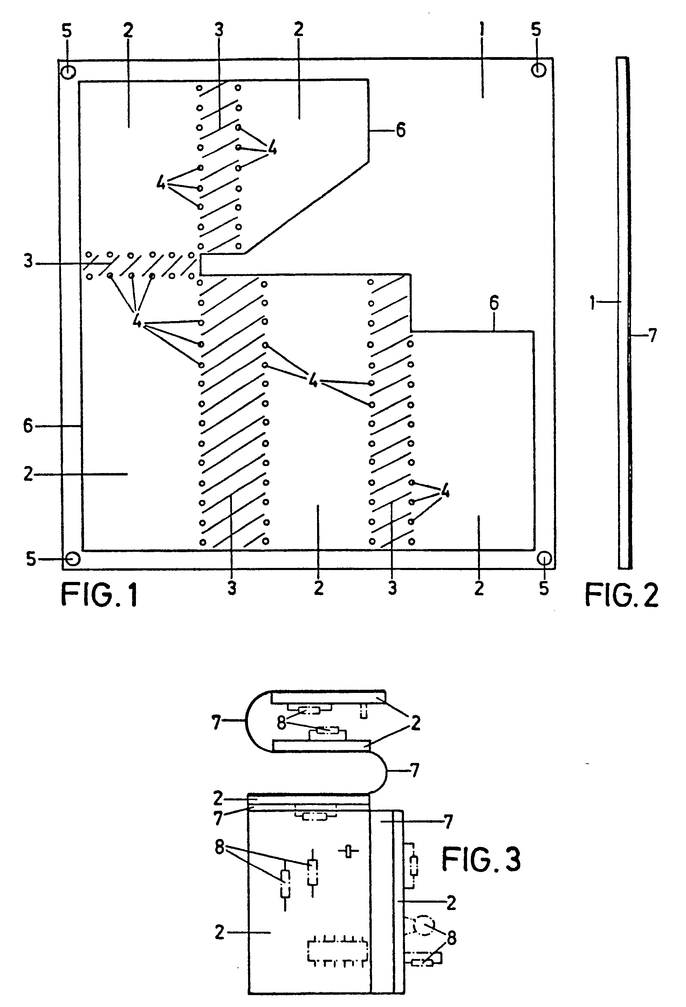

Aus der Fig. 1 ist eine unkaschierte Basisplatte 1 zu erkennen, die nach verschiedenen Bearbeitungsvorgängen zu einer mit elektrischen Bauteilen bestückten Leiterplatte komplettiert wird. Ausgehend von der Basisplatte wird nach bestimmten Bearbeitungsschritten eine Leiterplatte erhalten, die starre Bereiche 2 und flexible Bereiche 3 aufweist, wobei die gewünschten flexiblen Bereiche in der Zeichnung schraffiert dargestellt sind. An den Randzonen der vorgesehenen flexiblen Bereiche ist die Basisplatte durch Aneinanderreihen von Durchbrüchen 4 perforiert. Die rechteckige Basisplatte 1 weist in den Eckbereichen Passbohrungen 5 auf, die in bekannter Weise zur genauen Aufnahme für die einzelnen Druckvorgänge dienen. Die auf der Basisplatte vorgezeichneten äusseren Konturen 6 zeigen bereits die endgültigen Umrisse der mit einem Konturschnitt auszustanzenden Leiterplatte. Die äusseren Konturen sind in der dargestellten Zeichnung nur zur Verdeutlichung der späteren Leiterplattenform eingezeichnet, um die verschiedenen starren und flexiblen Bereiche besser erkennen zu können. Nach oder auch vor dem Einbringen der Durchbrüche 4 für die vorgesehenen Perforationslinien werden nur die gewünschten starren Bereiche 2 der späteren Leiterplatte mit einem meist thermisch reaktivierbaren Kleber versehen. Der Kleber wird hierbei vorzugsweise im Siebdruckverfahren aufgebracht. Die schraffierten Bereiche 3 weisen somit keinen Kleber auf. Die Basisplatte kann bedarfsweise auch einseitig metallkaschiert sein, wobei dann die kaschierte Seite auf der kleberabgewandten Seite sich befindet und durch spätere Bearbeitungsvorgänge entsprechende Bahnen aufweist. Das Basismaterial besteht vorzugsweise aus Phenolharz-Hartpapier oder Epoxydharz-Hartpapier, wobei auch andere Werkstoffe verwendbar sind. Nach dem aufgetragenen Kleber wird eine einseitig metall-kaschierte flexible Folie 7 auf die Basisplatte aufgeklebt, wie nach Fig. 2 ersichtlich ist. Die vorgesehenen flexiblen Bereiche der späteren Leiterplatte weisen somit zwischen Basisplatte und flexibler Folie keine Verklebung auf. Die Metallkaschierung der flexiblen Folie besteht vorzugsweise aus einer Cu-Kaschierung. Der Träger der flexiblen Folie besteht vorzugsweise aus thermoplastischem Kunststoff oder aus Epoxydharzgewerbe.

Die Weiterverarbeitung der Basisplatte mit aufgeklebter flexibler Folie erfolgt nach den bisher bekannten Verfahren zur Leiterbahnbildung, zur Lochung und Konturstanzung sowie für das Bestücken mit elektrischen Bauteilen und der anschliessenden Verlötung. Bei der nun nach den angedeuteten Verfahren komplettierten Leiterplatte werden durch Bruchtrennen die starren von den flexiblen Bereichen getrennt. Das Bruchtrennen erfolgt durch leichtes Biegen der Leiterplatte entlang den Perforationslinien. Hierdurch entfallen die starren Verbindungsstücke zwischen einem starren Bereich zum anderen starren Bereich.

Nach Fig. 3 ist zu erkennen, in welcher Lage die nach dem Bruchtrennen erhaltene komplette Leiterplatte in einem Gerät eingesetzt werden kann. Zur besseren Verdeutlichung der einzelnen Abschnitte sind auf den starren Bereichen die aufgesetzten Bauteile 8 strichpunktiert angedeutet.

Der flexible Bereich kann wie der starre Bereich nach dem beschriebenen Verfahren nahezu eine beliebige Form annehmen. Weiterhin kann der flexible Bereich Konturausstanzungen aufweisen, die der besseren Formveränderung der Leiterplatte dienen, oder damit Teile des Gerätes oder der Leiterplatte durch den flexiblen Bereich hindurchragen können. Es ist auch in gleicher Weise durch Bruchtrennen möglich, dass die flexiblen Bereiche starre Inseln mit aufgebrachten Bauteilen besitzen, sofern dies bei der Beschichtung und der Perforierung berücksichtigt ist.

Die Perforierung kann auf verschiedenste Weise ausgeführt sein, so sind nicht nur runde Lochreihen sondern auch Schlitzreihen möglich, auch können versetzte Lochreihen vorgesehen sein, um die verbleibenden Verbindungsstege möglichst schmal zu halten. Durch entsprechend ausgebildete Perforationslinien kann erreicht werden, dass einerseits ein leichtes Bruchtrennen gewährleistet ist und andererseits die Festigkeit aller Leiterplattenbereiche, insbesondere während eines automatischen Bauteil-Bestückungsvorganges, noch ausreichend stabil ist.

Das Aufbringen der flexiblen Folie auf die Basisplatte geschieht nach verschiedenen Verfahren. Zweckmässigerweise werden heisssiegelfähige Kleber verwendet, und die Folie wird zwischen geheizten Walzen auf die Leiterplatte auflaminiert. Es ist auch das Aufbringen der Folie auf die Basisplatte durch Verpressen möglich.

## Patentansprüche

1. Verfahren zum Herstellen von Leiterplatten mit starren (2) und flexiblen (3) Bereichen beliebiger geometrischer Formen, wobei die flexiblen Bereiche (3) als Träger eine flexible Folie (7) aufweisen und bei allen Bearbeitungs- und Bestückungsvorgängen mit den starren Bereichen fest verbunden sind und das Verfahren die folgenden Schritte aufweist:
a) Eine unkaschierte oder einseitig metallkaschierte starre Basisplatte (1) wird an den Randzonen der vorgesehenen flexiblen Bereiche (3) durch Aneinanderreihen von Durchbrüchen (4) perforiert,
b) eine einseitig metallkaschierte flexible Folie (7) wird auf die Basisplatte aufgeklebt, wobei die als flexibel vorgesehenen Bereiche der Leiterplatte nicht verklebt werden.
c) die Weiterverarbeitung der Basisplatte mit aufgeklebter flexibler Folie erfolgt nach den bisher bekannten Verfahren zur Leiterbahnbildung, Lochung, Konturstanzung, Bestückung mit Bauteilen, Verlötung etc., und
d) durch Bruchtrennen, das durch leichtes Biegen entlang den Perforationslinien erfolgt, werden die starren von den flexiblen Bereichen der komplett aufgebauten Leiterplatte getrennt.

2. Verfahren nach Anspruch 1, dadurch gekennzeichnet, dass die Perforierung der Basisplatte in Form von gestanzten Lochreihen oder Schlitzen erfolgt.

3. Verfahren nach den Ansprüchen 1 und 2, dadurch gekennzeichnet, dass als Werkstoff der Basisplatte Phenolharz-Hartpapier, Epoxydharz-Hartpapier, Epoxyd-Glasgewebe oder lötbeständige Thermoplaste verwendet werden.

4. Verfahren nach den Ansprüchen 1 bis 3, dadurch gekennzeichnet, dass die Perforierung in einer aus thermoplastischem Kunststoff gespritzten Basisplatte bereits mit dem Spritzvorgang eingebracht wird.

5. Verfahren nach einem der vorherigen Ansprüche, dadurch gekennzeichnet, dass der Abstand der einzelnen Lochungen für die Lochreihen zur Perforierung bestimmter Basisplattenbereiche dem genormten Abstand vorhandener Lochungseinrichtungen von Leiterplatten entspricht.

6. Verfahren nach einem der bisherigen Ansprüche, dadurch gekennzeichnet, dass die Metall-Kaschierung der flexiblen Folie aus einer Cu-Kaschierung besteht.

7. Verfahren nach Anspruch 6, dadurch gekennzeichnet, dass der Träger der Cu-kaschierten flexiblen Folie aus einem thermosplastischen Kunststoff oder aus Epoxydglasharzgewebe besteht.

8. Verfahren nach einem der bisherigen Ansprüche, dadurch gekennzeichnet, dass die flexible Folie über einen Heisskleber auf die Basisplatte haftend aufgewalzt wird.

9. Verfahren nach einem der bisherigen Ansprüche, dadurch gekennzeichnet, dass der Kleber im Siebdruckverfahren auf die zu klebenden Bereiche auf die Basisplatte aufgebracht wird.

10. Verfahren nach einem der bisherigen Ansprüche, dadurch gekennzeichnet, dass die aus thermoplastischem Kunststoff bestehende flexible Folie durch Heissverpressen mit der Basisplatte verbunden wird.

11. Verfahren nach einem der bisherigen Ansprüche, dadurch gekennzeichnet, dass der flexible Bereich der Leiterplatte Konturausstanzungen aufweist.

## Claims

1. Method for producing printed circuit boards with rigid (2) and flexible (3) regions of any geometrical shapes, in which method the flexible regions (3) have a flexible film (7) as carrier and are solidly connected to the rigid regions in all the processing and mounting operations and the method has the following steps:
a) a rigid base boared (1), unclad or metal-clad on one side, is perforated at the peripheral zones of the planned flexible regions (3) by arranging perforations (4) in rows,
b) a flexible film (7), metal-clad on one side, is glued onto the base board, the regions of the printed circuit board planned to be flexible not being provided with glue,
c) the further processing of the base board with the flexible film glued to it is carried out by the hitherto known method for conductor track formation, perforation, outline punching, mounting of components, soldering, etc., and
d) as a result of separation by breaking, which is carried out by lightly bending along the perforation lines, the rigid regions of the completely constructed printed circuit board are separated from the flexible ones.

2. Method according to Claim 1, characterized in that the perforation of the base board is carried out in the form of punched rows of holes or of slits.

3. Method according to Claims 1 and 2, characterized in that phenolic resin laminated paper, epoxy laminated paper, epoxy glass fabric or solder-resistant thermoplastics are used as the material for the base board.

4. Method according to the Claims 1 to 3, characterized in that the perforations have already been introduced into a base board injection-moulded from thermoplastic material during the injection-moulding process.

5. Method according to one of the preceding claims, characterized in that the spacing of the individual perforations for the rows of holes for the perforation of certain base board regions corresponds to the standdardized spacing of existing printed circuit board perforation equipment.

6. Method according to one of the preceding claims, characterized in that the metal cladding of the flexible film consists of a Cu cladding.

7. Method according to Claim 6, characterized in that the carrier of the Cu-clad flexible film consists of a thermoplastic material or of an epoxy glass resin fabric.

8. Method according to one the precding claims, characterized in that flexible film is adhesively rolled onto the base board using a hot-setting adhesive.

9. Method according to one of the preceding claims, characterized in that the adhesive is applied to the regions to be glued on the base board by the screen printing method.

10. Method according to one of the preceding claims, characterized in that the flexible film consisting of thermoplastic material is joined to the base board by hot press moulding.

11. Method according to one of the preceding claims, characterized in that the flexible region of the printed circuit board has punched outlines.

## Revendications

1. Procédé pour fabriquer des plaquettes de circuits imprimés comportant des domaines rigides (2) et des domaines flexibles (3), qui possèdent des formes géométriques quelconques, les domaines flexibles (3) comportant, en tant que support, une feuille flexible (7) et étant reliés fermement aux domaines rigides, pendant toutes les opérations de traitement et de montage des composants, ce procédé comprenant les étapes opératoires suivantes:
(a) on perfore une plaque de base rigide (1) ne comportant aucun doublage ou comportant un doublage métallique sur l'une de ses faces, au niveau des zones marginales des domaines flexibles (3) prévus, en aménageant des rangées, disposées côté à côte, de perçages (4),
(b) on colle une feuille flexible (7) comportant un doublage métallique sur l'une de ses faces, sur la plaque de base sans fixer par collage les domaines de la plaquette de circuits imprimés, prévus en tant que domaines flexibles,

(c) on poursuit le traitement de la plaque de base munie de la feuille flexible collée conformément aux procédés connus jusqu'alors pour former les voies conductrices, percer des trous, découper des contours, monter des composants, effectuer des soudures, etc. et
(d) on sépare les domaines rigides des domaines flexibles de la plaquette de circuits imprimés complètement terminée au moyen d'une opération de séparation par rupture, qui est exécutée au moyen d'un léger pliage le long des lignes perforations.

2. Procédé selon la revendication 1, caractérisé en ce que l'aménagement de perforations dans la plaque de base s'effectue sous la forme de séries de trous ou de fentes découpés.

3. Procédé selon la revendication 1 ou 2, caractérisé en ce qu'on utilise comme matériau de la plaque de base, du papier dur/résine phénolique, du papier dur/résine époxy, du tissu de verre époxy ou des thermoplastes résistants à la soudure.

4. Procédé selon les revendications 1 à 3, caractérisé en ce qu'on exécute les perforations dans une plaque de base moulée par injection d'une matière thermoplastique, déjà lors de l'opération de moulage par injection.

5. Procédé selon l'une des revendications précédentes, caractérisé en ce que la distance entre les différents trous des rangées de trous utilisés pour exécuter des perforations dans des zones déterminées de la plaque de base correspond à la distance normalisée entre des dispositifs de perforation existants et les plaquettes de circuits imprimés.

6. Procédé selon l'une des revendications précédentes, caractérisé en ce que le doublage métallique de la feuille flexible est constitué par un doublage en Cu.

7. Procédé selon la revendication 6, caractérisé en ce que le support de la feuille flexible doublée de Cu est constitué par une matière thermoplastique ou par un tissu de résine époxy-verre.

8. Procédé selon l'une des revendications précédentes, caractérisé en ce que la feuille flexible est appliquée par un rouleau de manière à adhérer à la plaque de base au moyen d'une colle fusible.

9. Procédé selon l'une quelconque des revendications précédentes, caractérisé en ce qu'on dépose la colle selon le procédé de sérigraphie sur les zones, devant être collées, situées sur la plaque de base.

10. Procédé selon l'une des revendications précédentes, caractérisé en ce qu'on relie la feuille flexible constituée par une matière thermoplastique à la plaque de base, par compression à chaud.

11. Procédé selon l'une des revendications précédentes, caractérisé en ce que le domaine flexible de la plaquette de circuits imprimés comporte des contours découpés.

FIG.1

FIG.2

FIG.3